# EUROPÄISCHE PATENTANMELDUNG

(11) **EP 2 692 907 A1**
(43) Veröffentlichungstag der Anmeldung: **05.02.2014**
(21) Anmeldenummer: 12179020.8
(22) Anmeldetag: 02.08.2012
(51) Int. Cl.: C30B 11/00, H05B 6/06

(54) **Stromversorgungsvorrichtung für eine Tiegelheizung und Verfahren zu deren Betrieb**

(71) Anmelder: Siemens Aktiengesellschaft, 80333 München (DE)
(72) Erfinder: Baumbach, Uwe, 08066 Zwickau (DE); Rudolph, Mike, 09116 Chemnitz (DE)

(57) **Zusammenfassung**

Die Erfindung betrifft eine Stromversorgungsvorrichtung (10, 62) für eine Tiegelheizung (28) einer Kristallzüchtungsanlage nach dem VGF-Verfahren und ein Verfahren zu deren Betrieb, wobei für zur Ansteuerung von Heizstromkreisen (26,32) vorgesehene Stromversorgungsmodule (12-20), die jeweils zumindest ein Schaltnetzteil umfassen, der jeweilige Ausgangsstrom der Stromversorgungsmodule (12-20) gemäß den Anforderungen aus dem Heizprozess und dem Magnetfelderzeugungsprozess präzise einstellbar ist.

## Beschreibung

Die Erfindung betrifft eine geregelte Stromversorgungsvorrichtung für eine Tiegelheizung einer Kristallzüchtungsanlage nach dem VGF-Verfahren ("Vertical Gradient Freeze"-Verfahren). Die Erfindung bezieht sich auch auf ein Verfahren zum Betrieb einer solchen Stromversorgungsvorrichtung.

Das VGF-Verfahren kann in folgende vier Phasen eingeteilt werden: (1) Aufschmelzen, (2) Homogenisieren, (3) Kristallisation und (4) Abkühlung. Als Heizquelle kommen üblicherweise niederohmige Graphitheizer zum Einsatz, wie dies in der EP 1 676 299 A beschrieben ist. Während der Abschnitte (1) bis (3) wird durch eine geeignete Stromversorgung neben der Heizleistung auch ein Wechselstrom für die Magnetfelderzeugung generiert. Für die Aufheizung des kristallinen Siliziums und die Homogenisierung der Schmelze werden magnetische Felder erzeugt, die eine schnelle Durchmischung der Schmelze bewirken. In der Phase der Kristallisation ist es u.a. notwendig, die Temperaturverteilung an der Phasengrenze (flüssige Phase zur festen Phase) zu nivellieren und somit thermische Spannungen im Kristall abzubauen, welche maßgeblich die Kristallqualität beeinflussen. Dies geschieht allgemein mittels magnetischer Wechselfelder, welche die Strömungen innerhalb der Siliziumschmelze bremsen oder befördern.

Für nach dem VGF-Verfahren arbeitende Kristallzüchtungsanlagen kommen bisher geregelte Stromversorgungsvorrichtungen zum Einsatz, welche nach dem Prinzip der Phasenanschnittsteuerung arbeiten. Durch den Betrieb dieser bekannten Stromversorgungsvorrichtungen ergeben sich zumindest die im Folgenden skizzierten Nachteile:
Die Prozesssteuerung für den Heizprozess lässt sich nicht entkoppelt von der Prozesssteuerung der Magnetfelderzeugung betreiben. Der Grund hierfür liegt in der direkten Abhängigkeit der Magnetfeldstärke von der Stromstärke.

Ein weiterer Nachteil ist, dass geregelte Stromversorgungsvorrichtungen, welche nach dem Prinzip der Phasenanschnittsteuerung arbeiten, im einspeisenden Netz im beträchtlichen Umfang Oberwellen bzw. Oberwellenblindleistung erzeugen. Industriekunden werden von ihrem Energieversorger angehalten, geeignete Maßnahmen zur Reduzierung der von ihnen verursachten Netzrückwirkung durchzuführen. Zusätzlich tritt bei diesen bekannten Stromversorgungen eine erhöhte Verschiebungsblindleistung, besonders im Teillastbereich auf. Der Leistungsfaktor als Quotient aus aufgenommener Wirkleistung und Scheinleistung sinkt. Blindleistungsverluste müssen durch gesonderte technische Maßnahmen begrenzt werden. Dies ist zum Beispiel durch den Einsatz von Kompensationsanlagen möglich. Ein weiterer Nachteil sind, besonders im Teillastbereich, beträchtliche Rippelspannungen. Hierdurch sinkt der Signalstörabstand. Eine präzise Temperaturregelung der Siliziumschmelze gestaltet sich dadurch schwieriger.

Aus der älteren, nicht vorveröffentlichten europäischen Patentanmeldung vom 01.08.2011 mit der Anmeldenummer 11176125.0 ist eine Stromversorgungsvorrichtung für eine Tiegelheizung bekannt, die mindestens einen Heizstromkreis umfasst, welcher seinerseits jeweils mindestens zwei Stromversorgungsmodule umfasst. Zur Ansteuerung der Stromversorgungsmodule ist eine Prozesssteuereinrichtung vorgesehen, wobei in dem oder jedem Heizstromkreis Ausgänge der mindestens zwei Stromversorgungsmodule parallel geschaltet sind. Die Einstellbarkeit der Heizleistung wird hier durch die Modularität der einzeln ansteuerbaren Stromversorgungsmodule gewährleistet.

Eine Aufgabe der vorliegenden Erfindung besteht darin, eine Stromversorgungseinrichtung für eine Tiegelheizung einer VGF-Kristallzüchtungsanlage so zu verbessern, dass die eingangs skizzierten Nachteile vermieden oder zumindest deren Auswirkungen reduziert werden.

Diese Aufgabe wird erfindungsgemäß mit den Merkmalen der unabhängigen Ansprüche gelöst.

Dabei ist bei einer Stromversorgungsvorrichtung für eine Tiegelheizung einer Kristallzüchtungsanlage, bei der die Stromversorgungsvorrichtung mindestens einen Heizstromkreis mit jeweils mindestens zwei Stromversorgungsmodulen sowie eine Prozesssteuereinrichtung zur Ansteuerung der Stromversorgungsmodule umfasst, vorgesehen, dass die Stromversorgungsmodule nach dem Prinzip von Schaltnetzteilen arbeiten und dafür ein oder mehrere Schaltnetzteile, zum Beispiel drei Schaltnetzteile, aufweisen und dass das oder jedes Schaltnetzteil einzeln mit einem Sollwert für einen ausgangsseitig abgreifbaren Gleich- und Wechselspannungsanteil ansteuerbar ist.

Schaltnetzteile sind an sich bekannt. Eine Verwendung von Schaltnetzteilen für eine Tiegelheizung einer Kristallzüchtungsanlage nach dem VGF-Verfahren ist bisher nicht bekannt geworden.

Der Vorteil der Erfindung besteht vor allem darin, dass in jedem Stromversorgungsmodul das oder jedes Schaltnetzteil einzeln mittel- oder unmittelbar mit einem Sollwert für eine ausgangsseitig abgreifbare Gleichspannung oder einen abgreifbaren Gleichspannungsanteil sowie einem Sollwert für eine ausgangsseitig abgreifbare Wechselspannung oder einen abgreifbaren Wechselspannungsanteil ansteuerbar ist. Die von der Tiegelheizung abgegebene Heizleistung kann damit unabhängig von einem von der Tiegelheizung erzeugten elektromagnetischen Wechselfeld eingestellt werden. Die Sollwerte für die beiden ausgangsseitig bereitgestellten Gleichspannungs- und Wechselspannungsanteile können dabei direkt oder auch indirekt in Form eines Gleich- und Wechselspannungsverhältnisses angegeben werden.

Die oben genannte Aufgabe wird auch mit einem Verfahren zum Betrieb einer Stromversorgungsvorrichtung für eine Tiegelheizung einer Kristallzüchtungsanlage, wie hier und im Folgenden beschrieben, bei der die Stromversorgungsvorrichtung mindestens einen Heizstromkreis mit jeweils mindestens zwei Stromversorgungsmodulen sowie eine Prozesssteuereinrichtung zur Ansteuerung der Stromversorgungsmodule umfasst, dadurch gelöst, dass zur Vorgabe einer Heizleistung der Tiegelheizung die Schaltnetzteile von der Prozesssteuereinrichtung angesteuert werden, indem zur Vorgabe einer Heizleistung der Tiegelheizung und zur Vorgabe eines von der Tiegelheizung erzeugten elektromagnetischen Wechselfeldes die Schaltnetzteile von der Prozesssteuereinrichtung einzeln mit einem Sollwert für einen ausgangsseitig abgreifbaren Gleichspannungsanteil sowie einem Sollwert für einen ausgangsseitig abgreifbaren Wechselspannungsanteil angesteuert werden.

Bei dem Verfahren zum Betrieb einer Stromversorgungsvorrichtung für eine Tiegelheizung einer Kristallzüchtungsanlage werden zur Vorgabe einer Heizleistung der Tiegelheizung und zur Vorgabe eines von der Tiegelheizung erzeugten elektromagnetischen Wechselfeldes in jedem Stromversorgungsmodul das oder jedes Schaltnetzteil von der Prozesssteuereinrichtung mit einem Sollwert für eine ausgangsseitig abgreifbare / verfügbare Gleichspannung oder einen ausgangsseitig abgreifbaren / verfügbaren Gleichspannungsanteil sowie einem Sollwert für eine ausgangsseitig abgreifbare Wechselspannung oder einen ausgangsseitig überlagerten Wechselspannungsanteil angesteuert.

Vorteilhafte Ausgestaltungen der Erfindung sind Gegenstand der Unteransprüche. Dabei verwendete Rückbeziehungen weisen auf die weitere Ausbildung des Gegenstandes des Hauptanspruches durch die Merkmale des jeweiligen Unteranspruches hin. Sie sind nicht als ein Verzicht auf die Erzielung eines selbständigen, gegenständlichen Schutzes für die Merkmalskombinationen der rückbezogenen Unteransprüche zu verstehen. Des Weiteren ist im Hinblick auf eine Auslegung der Ansprüche bei einer näheren Konkretisierung eines Merkmals in einem nachgeordneten Anspruch davon auszugehen, dass eine derartige Beschränkung in den jeweils vorangehenden Ansprüchen nicht vorhanden ist.

Bei einer Ausführungsform der Stromversorgungsvorrichtung umfasst diese eine zwischen die Prozesssteuereinrichtung und die Stromversorgungsmodule geschaltete Heizungssteuereinrichtung zur Steuerung und Überwachung der Stromversorgungsmodule und zur direkten und/oder indirekten Steuerung und Überwachung der Schaltnetzteile. Die Heizungssteuereinrichtung ist damit diejenige Funktionseinheit der Stromversorgungsvorrichtung, die für einen oder mehrere Parameter jeweils Sollwerte an die Stromversorgungsmodule und deren Schaltnetzteile ausgibt. Sie ist auch diejenige Funktionseinheit, die in Betracht kommt, um im Betrieb der Stromversorgungsvorrichtung für einen oder mehrere Parameter jeweilige Istwerte bei den Stromversorgungsmodulen aufzunehmen. Mit den oben genannten Sollwerten kann die von den Schaltnetzteilen jeweils an die Tiegelheizung abgegebene elektrische Leistung entsprechend dem jeweiligen Bedarf eingestellt werden. Mit solchen Sollwerten und darüber hinaus korrespondierenden Istwerten kann die Heizungssteuereinrichtung auch die Funktion einer Heizungsregelungseinrichtung übernehmen und bei Abweichungen zwischen einem Sollwert und einem korrespondierenden Istwert entsprechend einem jeweils implementierten Regelungsalgorithmus eingreifen.

Bei einer weiteren Ausführungsform der Stromversorgungsvorrichtung ist jedes Stromversorgungsmodul über eine Kommunikationsschnittstelle kommunikativ mit der Prozesssteuereinrichtung verbunden, zum Beispiel indem jedes Stromversorgungsmodul eine Kommunikationsschnittstelle umfasst oder indem alle Stromversorgungsmodule an eine gemeinsame und als Kommunikationsschnittstelle fungierende Kommunikationsschnittstelleneinheit angeschlossen sind. Über die Kommunikationsschnittstelle kann jedes Stromversorgungsmodul Status- und Steuerinformationen mit der Prozesssteuervorrichtung oder der Heizungssteuereinrichtung austauschen. Zum Beispiel kann bei einer Störung eines der Stromversorgungsmodule ein Signal über die Kommunikationsschnittstelle vom defekten Stromversorgungsmodul an die zwischen die Prozesssteuereinrichtung und die Stromversorgungsmodule geschaltete Heizungssteuereinrichtung übermittelt werden, woraufhin die Heizungssteuereinrichtung die Möglichkeit hat, das defekte Stromversorgungsmodul zu deaktivieren. Dazu sendet die Heizungssteuereinrichtung ein entsprechendes Deaktivierungssignal über deren Kommunikationsschnittstelle an das jeweilige Stromversorgungsmodul.

Bei einer Ausführungsform einer Stromversorgungsvorrichtung mit einzeln für einen ausgangsseitig abgreifbaren Gleich- und Wechselspannungsanteil vorgebbaren Sollwerten ist das oder jedes Schaltnetzteil darüber hinaus einzeln mit einem Sollwert für eine Phasenlage, eine Amplitude und eine Frequenz der ausgangsseitig abgreifbaren (verfügbaren) Wechselspannung / des ausgangsseitig abgreifbaren Wechselspannungsanteils ansteuerbar. Das von der Tiegelheizung im Betrieb erzeugte Wechselfeld und die dafür ursächlichen, von den einzelnen Stromversorgungsmodulen / Schaltnetzteilen generierten Wechselspannungen kann bzw. können damit sehr genau eingestellt werden. Ein veränderbares Wechselfeld ist entsprechend dem Prozessfortschritt bei der Kristallzüchtung erforderlich, um für das Kristallwachstum optimale Verhältnisse bezüglich Konvektion, Strömung und Temperaturverlauf der Halbleiterschmelze zu erreichen.

Bei einer Ausführungsform des oben bereits beschriebenen Verfahrens werden zur Vorgabe einer Heizleistung der Tiegelheizung die Schaltnetzteile von der Prozesssteuereinrichtung angesteuert, insbesondere einzeln angesteuert.

Die oben genannte Aufgabe wird auch mit einer Prozesssteuereinrichtung zur Steuerung eines Heizprozesses einer Tiegelheizung einer Kristallzüchtungsanlage gelöst, die nach dem Verfahren wie hier und im Folgenden beschrieben arbeitet und dazu Mittel zur Durchführung des Verfahrens umfasst. Die Erfindung ist dabei bevorzugt in Software implementiert. Die Erfindung ist damit einerseits auch ein Computerprogramm mit durch einen Computer ausführbaren Programmcodeanweisungen und andererseits ein Speichermedium mit einem derartigen Computerprogramm, also ein Computerprogrammprodukt mit Programmcodemitteln, sowie schließlich auch eine Prozesssteuereinrichtung, in deren Speicher als Mittel zur Durchführung des Verfahrens und seiner Ausgestaltungen ein solches Computerprogramm geladen oder ladbar ist.

Der Vorteil der Erfindung und ihrer Ausgestaltungen besteht in der Möglichkeit zur präzisen Temperaturführung des Heizprozesses wie auch in der präzisen Magnetfelderzeugung.

Nachfolgend wird ein Ausführungsbeispiel der Erfindung anhand der Zeichnung näher erläutert. Einander entsprechende Gegenstände oder Elemente sind in allen Figuren mit den gleichen Bezugszeichen versehen.

Das oder jedes Ausführungsbeispiel ist nicht als Einschränkung der Erfindung zu verstehen. Vielmehr sind im Rahmen der vorliegenden Offenbarung auch Änderungen oder Modifikationen möglich, die zum Beispiel durch Kombination oder Abwandlung von einzelnen in Verbindung mit den im allgemeinen oder speziellen Beschreibungsteil beschriebenen sowie in den Ansprüchen und/oder der Zeichnung enthaltenen Merkmalen oder Verfahrensschritten für den Fachmann im Hinblick auf die Lösung der Aufgabe entnehmbar sind und durch kombinierbare Merkmale zu einem neuen Gegenstand oder zu neuen Verfahrensschritten bzw. Verfahrensschrittfolgen führen.

Es zeigen
- FIG 1: ein Ausführungsbeispiel der erfindungsgemäßen Stromversorgungsvorrichtung,
- FIG 2: eine primäre Spannungsversorgung und Kühlwasserversorgung,
- FIG 3: ein weiteres Ausführungsbeispiel der erfindungsgemäßen Stromversorgungsvorrichtung und
- FIG 4: eine mögliche Abfolge für die Steuerung von Heizprozess und Magnetfelderzeugungsprozess durch die Tiegelheizung durch eine Stromversorgungsvorrichtung gemäß FIG 1 oder FIG 3.

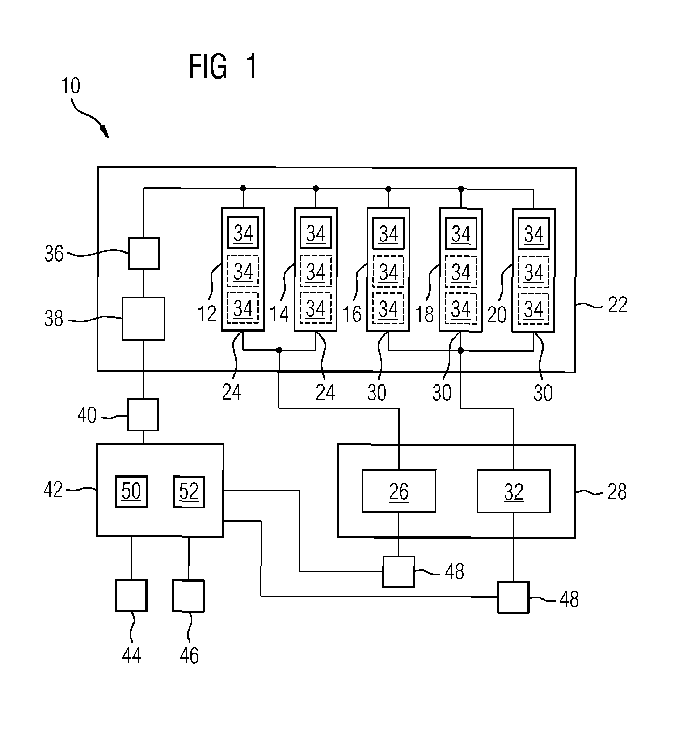

FIG 1 zeigt in schematisch vereinfachter Darstellung ein Ausführungsbeispiel der erfindungsgemäßen Stromversorgungsvorrichtung 10. Die Stromversorgungsvorrichtung 10 umfasst im dargestellten Ausführungsbeispiel fünf Stromversorgungsmodule 12, 14, 16, 18, 20, nämlich ein erstes, zweites, drittes, viertes und fünftes Stromversorgungsmodul 12-20, die beispielsweise in einem Schaltschrank 22 angeordnet sind. Die Ausgänge 24 eines ersten und zweiten Stromversorgungsmoduls 12, 14 sind mittels einer Stromschiene (nicht dargestellt) parallel geschaltet und versorgen einen ersten Heizstromkreis 26 einer Tiegelheizung 28. Die Ausgänge 30 eines dritten, vierten und fünften Stromversorgungsmoduls 16-20 sind ebenfalls parallel geschaltet und versorgen einen zweiten Heizstromkreis 32 der Tiegelheizung 28.

Jedes Stromversorgungsmodul 12-20 verfügt über zumindest ein an sich bekanntes Schaltnetzteil 34 mit zumindest einer Gleichrichtereinheit, einem Leistungswandler mit Übertrager und einem Weitbereichsausgang. Weil Schaltnetzteile 34 an sich bekannt sind, kann auf die Darstellung von Einzelheiten verzichtet werden. Darüber hinaus verfügen die Stromversorgungsmodule 12-20 zusammen oder jedes Stromversorgungsmodul 12-20 einzeln über eine Kommunikationsschnittstelle/-bus 36, um Status- und Steuerinformationen übermitteln und austauschen zu können, wie im Folgenden beschrieben.

Die Steuerung und Überwachung der einzelnen Stromversorgungsmodule 12-20 erfolgt durch eine Heizungssteuereinrichtung 38, welche über die Kommunikationsschnittstelle/-bus 36 mit den Stromversorgungsmodulen 12-20 kommuniziert und innerhalb oder außerhalb des Schaltschranks 22 angeordnet ist. Die Heizungssteuereinrichtung 38 ist mit einer weiteren Kommunikationsschnittstelle 40 mit einer Prozesssteuereinrichtung 42 verbunden und wird von dieser gesteuert. Status- und Fehlermeldungen, die sich aufgrund einer Überwachung der Tiegelheizung 28 während des Betriebs der Tiegelheizung 28 zum Beispiel von einer Kühlwasserüberwachung 44, einer Drucküberwachung 46 und einer Temperaturüberwachung 48 ergeben, laufen, wie in FIG 1 dargestellt, direkt auf die Prozesssteuereinrichtung 42 auf.

Die Prozesssteuereinrichtung 42 umfasst eine Verarbeitungseinheit 50 in Form von oder nach Art eines Mikroprozessors und einen Speicher 52 zum Ausführen bzw. Speichern eines Computerprogramms für die Prozessüberwachung und Steuerung der Tiegelheizung 28. Anstelle der Prozesssteuereinrichtung 42 kann auch die Heizungssteuereinrichtung 38 eine solche Verarbeitungseinheit und einen Speicher umfassen (beides nicht dargestellt), um ein Computerprogramm für die Prozessüberwachung auszuführen bzw. zu speichern.

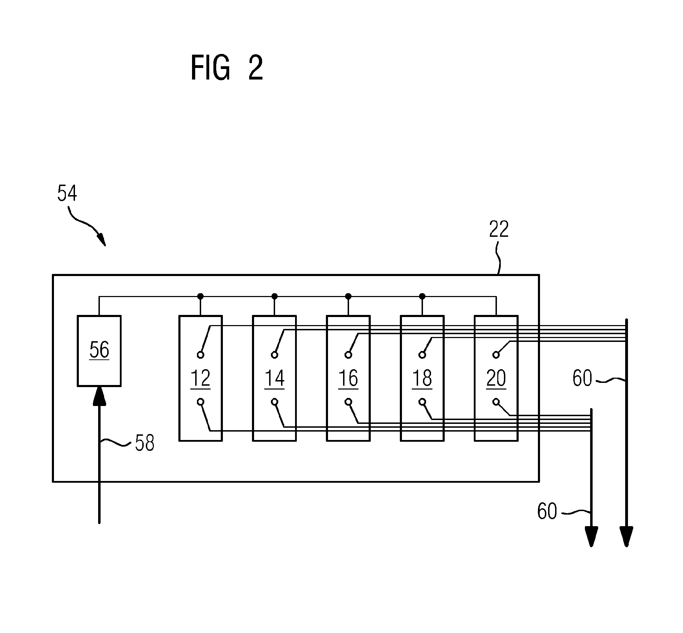

In FIG 2 ist ein Beispiel für eine primäre Spannungsversorgung 54 für die Stromversorgungsmodule 12-20 schematisch vereinfacht dargestellt. Die Spannungsversorgung 54 umfasst ein Schaltfeld 56, mit dem eine Versorgungsspannung 58 direkt auf die Stromversorgungsmodule 12-20 und deren Schaltnetzteile 34 (FIG 1) geführt wird. Jedes Stromversorgungsmodul 12-20 ist einzeln an einen Kühlwasserkreislauf 60 angeschlossen.

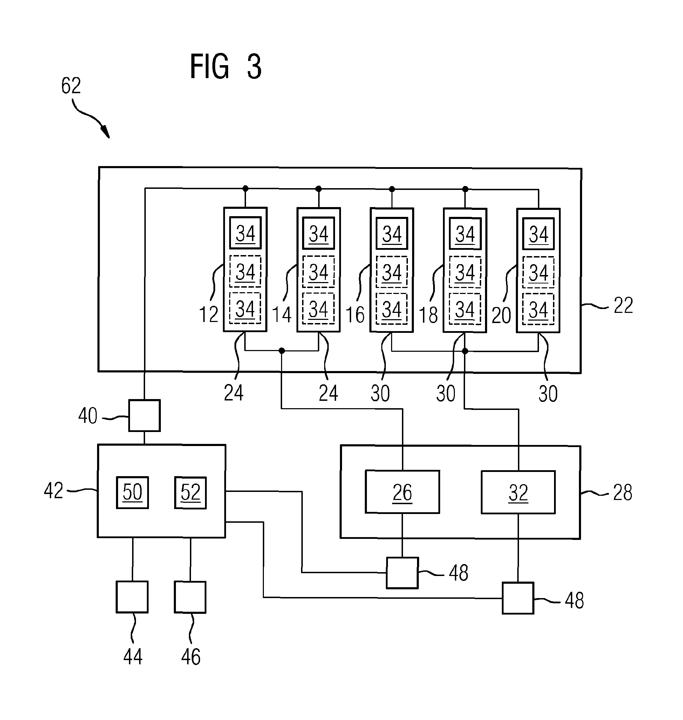

FIG 3 zeigt ein weiteres Ausführungsbeispiel einer erfindungsgemäßen Stromversorgungsvorrichtung 62, bei der die Stromversorgungsmodule 12-20 direkt mit der Kommunikationsschnittstelle 40 der Prozesssteuereinrichtung 42 verbunden sind und durch die Prozesssteuereinrichtung 42 direkt überwacht und gesteuert werden.

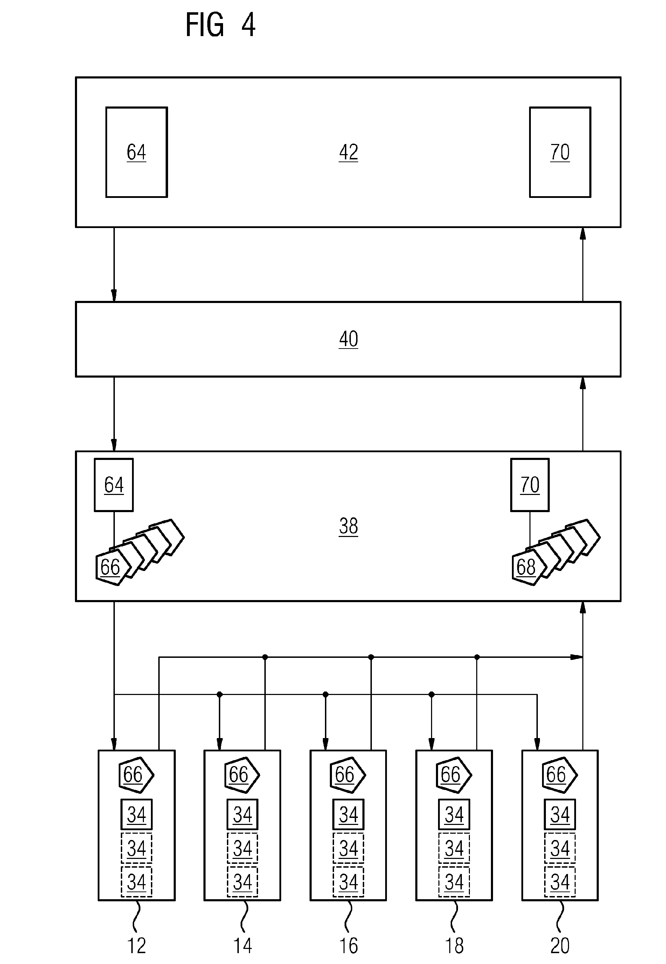

FIG 4 veranschaulicht eine mögliche Abfolge für die Steuerung von Heizprozess und Magnetfelderzeugungsprozess. Die Prozesssteuereinrichtung 42 liefert mit ihrer Verarbeitungseinheit 50 und unter Kontrolle des im Speicher 52 gespeicherten Computerprogramms für die Prozessüberwachung und Steuerung der Tiegelheizung 28 (FIG 1, FIG 3) Sollwerte für den Ausgangsstrom der Stromversorgungsmodule 12-20 in Form von Sollwerten für einzelne Parameter zur Ansteuerung der Stromversorgungsmodule 12-20 und der davon umfassten Schaltnetzteile 34 über die Kommunikationsschnittstelle 40 an die Heizungssteuereinrichtung 38. Mit diesen Parametern werden die am Ausgang eines jeweiligen Schaltnetzteils 34 verfügbaren Gleich- und Wechselspannungsanteile vorgegeben. Der resultierende Effektivwert, gebildet aus Gleich- und Wechselspannungsanteil bestimmt die Heizleistung. Dabei kann der Wechselspannungsanteil entweder als absoluter Effektivwert-Parameter angegeben oder als Verhältniswert von Gleich- und Wechselspannungsanteil beschrieben werden. Als optionale weitere Parameter kommen zum Beispiel in Betracht: Eine Phasenlage eines am Ausgang eines jeweiligen Schaltnetzteils 34 verfügbaren Wechselspannungsanteils, eine Amplitude dieser Wechselspannung, eine Frequenz der Wechselspannung, usw..

Diese Sollwerte werden jeweils in Form eines Sollwertedatensatzes 64 übermittelt. Die Heizungssteuereinrichtung 38 setzt die in dem Sollwertedatensatz 64 erhaltenen Sollwerte jeweils in individuelle Sollwerte für die Stromversorgungsmodule 12-20 und deren Schaltnetzteile 34 um. Bei den für das dargestellte Ausführungsbeispiel angenommenen fünf Stromversorgungsmodulen 12-20 erzeugt die Heizungssteuereinrichtung 38 demnach fünf Ansteuerungsdatensätze 66. Diese enthalten optional jeweils individuelle Sollwerte für zum Beispiel die oben genannten Parameter für jedes Schaltnetzteil 34. Im einfachen Fall wird der Ansteuerdatensatz 66 von den Stromversorgungsmodulen 12-20 selbst auf die umfassten Schaltnetzteile 34 umgerechnet und verteilt. Jedes Schaltnetzteil 34 erzeugt gemäß den so erhaltenen Sollwerten einen Ausgangsstrom mit einem durch die Sollwerte vorgegebenen Gleichspannungs- und Wechselspannungsanteil, wobei der Wechselspannungsanteil wie vorgenannt hinsichtlich Frequenz, Phasenlage und Amplitude genauer spezifizierbar ist.

Aufgrund der Überwachung der Stromversorgungsmodule 12-20 und der davon jeweils umfassten Schaltnetzteile 34 liefern diese im Betrieb Istwerte der oben genannten Parameter an die Heizungssteuereinrichtung 38. Dabei ergibt sich von jedem der hier fünf Stromversorgungsmodule 12-20 jeweils ein Istwertedatensatz 68.

Jeder Istwertedatensatz 68 und die davon umfassten Istwerte kann auf der Ebene der Heizungssteuerung 38 zur Regelung der Stromversorgungsmodule 12-20 und deren Schaltnetzteile 34 verwendet werden.

Darüber hinaus kann aus der der Anzahl der Stromversorgungsmodule 12-20 entsprechenden Anzahl von Istwertedatensätzen 68 auch genau ein Kontrolldatensatz 70 generiert werden, zum Beispiel durch Bildung der Mittelwerte der von den Istwertedatensätzen 68 umfassten Istwerte. Dieser Kontrolldatensatz 70 kann auf der Ebene der Prozesssteuereinrichtung 42 für eine übergeordnete Regelung und für eine dynamische Anpassung der von der Prozesssteuereinrichtung 42 generierten Sollwerte 64 verwendet werden.

Obwohl die Erfindung im Detail durch das Ausführungsbeispiel näher illustriert und beschrieben wurde, so ist die Erfindung nicht durch das oder die offenbarten Beispiele eingeschränkt und andere Variationen können vom Fachmann hieraus abgeleitet werden, ohne den Schutzumfang der Erfindung zu verlassen.

Einzelne im Vordergrund stehende Aspekte der hier eingereichten Beschreibung lassen sich damit kurz wie folgt zusammenfassen: Angegeben werden eine Stromversorgungsvorrichtung 10, 62 für eine Tiegelheizung 28 einer Kristallzüchtungsanlage nach dem VGF-Verfahren und ein Verfahren zu deren Betrieb, wobei für zur Ansteuerung von zumindest einem Heizstromkreis 26, 32 der Tiegelheizung 28 vorgesehene Stromversorgungsmodule 12-20, bei denen jeweils mindestens ein Schaltnetzteil 34 als Stromversorgungsmodul 12-20 fungiert, der jeweilige Ausgangsstrom der Stromversorgungsmodule 12-20 bzw. Schaltnetzteile 34 präzise einstellbar ist, insbesondere getrennt in Form eines Gleichstrom- und Wechselstromanteils zur definierten entkoppelten Erzeugung einer gewünschten Heizleistung und eines magnetischen Wechselfeldes in der Halbleiterschmelze.

## Patentansprüche

1. Stromversorgungsvorrichtung (10,62) für eine Tiegelheizung (28) einer Kristallzüchtungsanlage nach dem VGF-Verfahren, wobei die Stromversorgungsvorrichtung (10,62) mindestens einen Heizstromkreis (26,32) mit jeweils mindestens zwei Stromversorgungsmodulen (12,14,16,18,20) sowie eine Prozesssteuereinrichtung (42) zur Ansteuerung der Stromversorgungsmodule (12,14,16,18,20) umfasst, **dadurch gekennzeichnet, dass** die Stromversorgungsmodule (12-20) ein oder mehrere Schaltnetzteile (34) aufweisen und dass jedes Schaltnetzteil (34) einzeln mit einem Sollwert (66) für einen ausgangsseitig abgreifbaren Gleich- und Wechselspannungsanteil ansteuerbar ist.

2. Stromversorgungsvorrichtung (10,62) nach Anspruch 1, mit einer zwischen die Prozesssteuereinrichtung (42) und die Stromversorgungsmodule (12-20) geschalteten Heizungssteuereinrichtung (38) zur Steuerung und Überwachung der Schaltnetzteile (34).

3. Stromversorgungsvorrichtung (10,62) nach einem der Ansprüche 1 oder 2, wobei jedes Stromversorgungsmodul (12,14,16, 18,20) über eine Kommunikationsschnittstelle (40) mit der Prozesssteuereinrichtung (42) kommunikativ verbunden ist.

4. Stromversorgungsvorrichtung (10,62) nach einem der Ansprüche 1 bis 3, wobei jedes Schaltnetzteil (34) einzeln mit einem Sollwert (66) für eine Phasenlage, eine Amplitude und eine Frequenz des ausgangsseitig abgreifbaren Wechselspannungsanteils ansteuerbar ist.

5. Verfahren zum Betrieb einer Stromversorgungsvorrichtung (10,62) für eine Tiegelheizung (28) einer Kristallzüchtungsanlage nach einem der Ansprüche 1 bis 4, **dadurch gekennzeichnet , dass** zur Vorgabe einer Heizleistung der Tiegelheizung (28) die Schaltnetzteile (34) von der Prozesssteuereinrichtung (42) angesteuert werden, indem zur Vorgabe einer Heizleistung der Tiegelheizung (28) und zur Vorgabe eines von der Tiegelheizung (28) erzeugten elektromagnetischen Wechselfeldes die Schaltnetzteile (34) von der Prozesssteuereinrichtung (42) einzeln mit einem Sollwert (66) für einen ausgangsseitig abgreifbaren Gleichspannungsanteil sowie einem Sollwert (66) für einen ausgangsseitig abgreifbaren Wechselspannungsanteil angesteuert werden.

6. Computerprogramm oder Computerprogrammprodukt mit auf einem computerlesbaren Datenträger gespeicherten Programmcodemitteln zur Ausführung aller Schritte des Verfahrens gemäß Anspruch 5, wenn das Computerprogramm oder Computerprogrammprodukt auf einer Prozesssteuereinrichtung (42) oder Heizungssteuereinrichtung (38) ausgeführt wird.

7. Digitales Speichermedium mit elektronisch auslesbaren Steuersignalen, die so mit einer programmierbaren Prozesssteuereinrichtung (42) oder Heizungssteuereinrichtung (38) zusammenwirken können, dass ein Verfahren nach Anspruch 5 ausgeführt wird.

8. Prozesssteuereinrichtung (42) oder Heizungssteuereinrichtung (38) mit einer Verarbeitungseinheit (50) und einem Speicher (52), in den ein Computerprogramm nach Anspruch 6 geladen ist, das im Betrieb des Gerätes durch die Verarbeitungseinheit (50) ausgeführt wird.
